(19)

Europäisches
Patentamt
European
Patent Office
Office européen
des brevets

(11) **EP 2 733 498 A2**

(12) **EUROPEAN PATENT APPLICATION**

(43) Date of publication:
21.05.2014 Bulletin 2014/21

(51) Int Cl.:
*G01R 31/08* *(2006.01)*

(21) Application number: 13192955.6

(22) Date of filing: 14.11.2013

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **15.11.2012 CN 201210460491**

(71) Applicant: **Schneider Electric Industries SAS
92500 Rueil-Malmaison (FR)**

(72) Inventors:
• **Li, Rong**
  **201114 Shanghai (CN)**
• **Ren, Rui**
  **201114 Shanghai (CN)**

(74) Representative: **Manitz, Finsterwald & Partner
GbR
Martin-Greif-Strasse 1
80336 München (DE)**

(54) **Method and device for detecting directional grounding fault based on three phase current variation**

(57)     A method for determining a fault phase during a single phase grounding fault and determining whether the fault is a downstream fault or a upstream fault. The present invention provides A directional grounding fault detecting method, comprising: a. detecting a grounding fault based on sampled three phase currents $i_A$, $i_B$ and $i_C$, and obtaining a time point t corresponding to an moment at which the grounding fault is just detected; b. determining whether it is a single phase grounding fault or a two phase grounding fault based on three incremental phase currents $\Delta i_A$, $\Delta i_B$ and $\Delta i_C$ at moment t; and c. when it is determined as a single phase grounding fault, it is determined whether the fault is an upstream fault or a downstream fault based on an amplitude of the incremental phase current of the faulted phase.

Figure 1

EP 2 733 498 A2

**Description**

Field of the invention

The present invention relates to a method and device for detecting grounding fault, more particularly to a method and device for detecting a directional grounding fault based on a three phase current variation during a transient period.

Background

In the power distribution network, there often exist a lot of tree-like branches. In the network, a plurality of FPI (Fault Passage Indicator) are usually mounted on each geographical key position. These FPIs will detect various types of faults, and some FPIs also determine fault directions. The fault whose occurrence probability is the greatest (about 70%) in the power distribution network is a single-phase grounding fault. Therefore, for both of DNOs (distribution network operators) locating quickly and repairing fault parts and electricity energy terminal users reducing their duration of suffering outage, economic and reliable single phase grounding fault detection and single phase grounding fault direction determination is very important.

There is described, in European patent EP239098A1, a method and device for detecting an intermittent fault in a multiple feeder system. It measures a voltage on a peterson coil, calculates a first-order derivative, and then calculates a correlation factor of each feeder loop current, and the feeder having a highest correlation factor is detected as having a grounding fault. The patent adopts a voltage measurement and is only applicable to a system in which a neutral point is grounded via a peterson coil.

There is disclosed, in Patent WO2011023305A1, a method of fault phase selection and fault type determination. The method adopts an indicator to determine whether it is a phase-phase fault, a three phase fault or a grounding fault. The method measures a phase-phase current and uses a sharing coefficient to determine various types of faults, but it does not provide information on direction determination.

There is described, in Japanese Patent JP2009526203, a method for detecting a grounding fault and an apparatus for powering a cable. The method provides a threshold of estimated average voltage or a variable derived therefrom, and compares it with a phase voltage. If the voltage or the variable derived therefrom is below the threshold, it is assumed that it is a grounding fault. The method only uses a voltage signal.

There is described, in Japanese Patent JP2009038912A, a method and apparatus for detecting a grounding fault. A zero sequence voltage sensor is used to detect a grounding fault in the whole system. Then the current in each feeder is used for calculating a resistance of each feeder. The calculated value is compared to a preset value, and the feeder having a resistance lower than the preset value is detected as having a grounding fault. The method uses a voltage signal and current to calculate an impedance variable.

There is disclosed, in Japanese Patent JP4215656B2, a grounding fault detecting apparatus and a grounding fault detecting method. The method measures three phase currents IA, IB and IC. Then each of the absolute values of |IA-IB|, |IB-IC| and |IC-IA| are compared to a preset value Iset for a grounding fault. If each of the absolute values is equal to or greater than the preset value, the grounding fault is detected. The method uses phase-phase current, but does not detect a direction.

There are provided three existing types of single phase grounding fault detecting algorithms adopted in the existing electric product scope as follows.

- a classical direction algorithm Residual currents and voltages are measured during fault transients. The sign of current I0 is compared to that of voltage V0, and if their signs are identical, then the fault is determined as an upstream fault, and opposite signs mean it is a downstream fault. Voltage information is obtained by measuring the electric field and magnetic field several meters downward from a line. The voltage measurement method is very sensitive to interference, such as an MV (medium voltage) or an HV (high voltage) line nearby. In addition, the electric field is very sensitive to an environment condition such as humility.

- a Ammetric algorithm The fault direction can not be determined by only measuring a residual current. Therefore, in order to lower the distance to be patrolled during a fault, an upstream fault is prohibited to be detected for Ammetric FPIs, and the threshold of the fault level should be set higher than a maximum possible capacitive current.

- an ICC algorithm (Insensitive to Capacitive Current) A three phase current is measured before a fault and during a fault. The algorithm has two principles: a maximum RMS (Root mean square) is based on a comparison of phase currents between a healthy phase and a fault phase. If there is occurred a downstream fault, there should be a phase current RMS (a fault party) greater obviously than the other two phase currents, and otherwise, the fault is an upstream fault. A correlation factor is based on the wave similarity between a phase current and a residual current. Downstream fault should have one of the phase currents being highly similar to residual current. The two principles can be used by combination or complementally. It is known the algorithm can not determine a fault direction reliably.

The method of the present invention disclosed as follows can overcome disadvantages of the above related art and the above mentioned algorithms.

Summary of the Invention

Additional aspects and advantages of the present invention will be set forth in the description which follows, and in part will be apparent from the description, or may be learned by practice of the invention.
The present invention discloses a method for detecting a single phase grounding fault in a power distribution network and determining its direction (whether the fault is an upstream fault or a downstream fault). The method uses three phase current signals before a fault time and after the fault time.
An object of the present invention is to implement an accurate fault direction determination by only using a current sensor.
The present invention provides a directional grounding fault detecting method, comprising: a. detecting a grounding fault based on sampled three phase currents $i_A$, $i_B$ and $i_C$, and obtaining a time point t corresponding to an moment at which the grounding fault is just detected; b. determining whether it is a single phase grounding fault or a two phase grounding fault based on three incremental phase currents $\Delta i_A$, $\Delta i_B$ and $\Delta i_C$ at moment t; and c. when it is determined as a single phase grounding fault, it is determined whether the fault is an upstream fault or a downstream fault based on an amplitude of the incremental phase current of the faulted phase.
The present invention further provides a directional grounding fault detecting device, comprising: a grounding fault detecting module for detecting a grounding fault based on sampled three phase currents $i_A$, $i_B$ and $i_C$, and obtaining a time point t corresponding to an moment at which the grounding fault is just detected; a single phase grounding fault determining module for determining whether it is a single phase grounding fault or a two phase grounding fault based on three incremental phase currents $\Delta i_A$, $\Delta i_B$ and $\Delta i_C$ at moment t; and, a fault direction determining module for, when it is determined as a single phase grounding fault, determining whether the fault is an upstream fault or a downstream fault based on an amplitude of the incremental phase current of the faulted phase.
Compared to other directional fault detecting methods in existing Flair/Flite FPIs, the method of the present invention has the following advantages:

- Greatly improving accuracy: ratio of a correct direction detection is greatly improved compared to an existing directional fault detecting algorithm based on current information (through batch simulation verification, the method of the present invention has a 100% accuracy rate under the used simulation platform).

- No need for a voltage sensor: compared to the traditional method, the present invention does not need to obtain voltage information. Therefore, the cost of the voltage sensor can be saved.

The present invention records a current (a load component) before a fault to subtract a load component from the measured current during the fault, so as to be able to extract a fault component containing more useful information corresponding to the characteristics of faults occurred at different locations.
The present invention detects the just beginning of a fault by using a sample value, and thus contains a transient signal of a high frequency charging and discharging capacitive current which is able to assist to determine a fault phase.

Brief description of the drawings

The above and other objects, features and advantages of the present invention will become more apparent from the detailed description of the preferred embodiments of the present invention in conjunction with the drawings in which like numbers refer to units having like structures and in which:

Fig. 1 shows a simplified equivalent circuit diagram of a faulted current during a single phase fault.

Fig. 2 shows a wave of a three phase current during a grounding fault of a phase A during a fault window (i.e., a first cycle after having detected a fault).

Fig. 3 shows a waveform of a three phase increment current $\Delta i$ during the fault window. Phase B and phase C are very close to each other so that they almost overlap with each other.

Fig. 4 shows a waveform of a three phase Δi obtained by amplifying the circled part of Fig. 3 during phase A grounding fault during the fault window.

Fig. 5 shows a flowchart of a method for determining a fault direction according to an embodiment of the present invention.

Fig. 6 shows a simplified schematic simulation circuit for a method for determining a directional grounding fault according the present invention.

Detailed description of the preferred embodiments

The present invention will be full described with reference to drawings showing an embodiment of the present invention. But the present invention can be implemented in many different ways, and should not be construed as being limited to the embodiments described herein. Rather, these embodiments are provided so that this disclosure will be thorough and complete, and will fully convey the scope of the present invention to those skilled in the art. In the drawings, components are exaggerated for the purpose of clearness.

It should be understood that, although the terms first, second, and third, etc. may be used herein to describe various elements, components and/or parts, these elements, components and/or parts should not be limited by these terms. These terms are only used to distinguish one element, component and/or part from another. Therefore, the first element, component and/or part discussed below could be termed a second element, component and/or part, without departing from the teaching of the present invention.

The terminology used herein is for the purpose of describing particular embodiments only and is not intended to be limiting of the present invention. As used herein, the singular forms "a," "an" and "the" are intended to include the plural forms as well, unless the context clearly indicates otherwise. It will be understood that the terms "comprises," when used herein, specify the presence of stated features, integers, steps, operations, elements and/or components, but do not preclude the presence or addition of one or more other features, integers, steps, operations, elements, components and/or groups thereof.

Unless otherwise defined, all terms (including technical and scientific terms) used herein have the same meaning as commonly understood by one of ordinary skill in the art to which the present invention belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

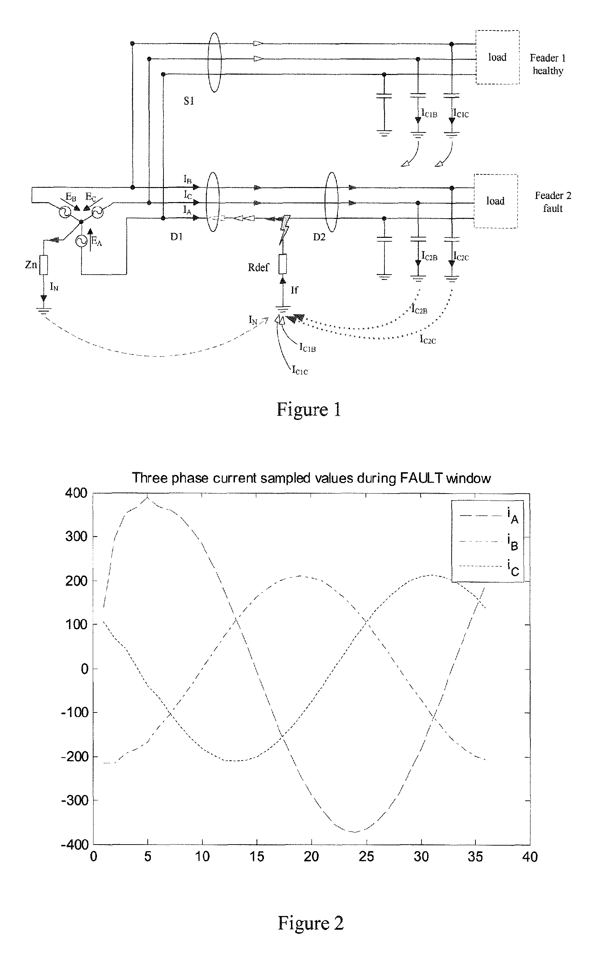

The principle for the fault identification method according to the present invention is as follows. Fig. 1 shows a simplified equivalent circuit diagram of faulted current during a single phase fault. Fig. 1 is a schematic simplified circuit diagram, and omits most of the following components: a transformer impedance, a longitudinal impedance of a feeder, coupling between feeders, an impedance of a grounding circuit, and a leakage impedance of a feeder. It is assumed that the load is linear and symmetrical.

During a normal operation, a load current and a capacitive current in three phases cancel out each other, so that no zero sequence current can be measured by an IED (intelligent electronic apparatus). During that it is short-circuited to the ground in phase A, for example, the voltage on phase A will decrease. The voltages on the other two phases will also change (in most cases, increase). This kind of voltage distortion will make the three phase capacitive current not balanced any more. Therefore, a residual current can be detected by the IED. When the transient value of the residual current exceeds a preset threshold (for example, 10A), it is considered a grounding fault is detected. Therefore, the time at which a fault starts is obtained, so that a direction determination can be made.

The residual current measured by IED D 1 at the position in Fig. 1 comprises a neutral point current IN and capacitive currents IC1(=IC1C+IC1B) from all adjacent feeders (herein, indicated only by feeder 1 in Fig. 1). The capacitive current (indicated by a solid arrow) of a fault feeder cancels out itself through flow in and flow out, and therefore, it can not be measured by the residual current. A fault phase current contains two parts: a load component and a fault component. The load component is not shown in the schematic circuit diagram, but the load component exists both before a fault and during the fault.

The fault components in the fault phase contain 5 arrows (two solid arrows, two hollow arrows and an unfilled arrow). If the sum of the neutral point current IN and the capacitive currents $I_{C1}$ from all adjacent feeders is a great enough value, then the fault component in the fault phase will have a value significantly greater than those of the fault components of the other two healthy phases (5 arrows in phase A >> one arrow in phases B and C). When the relation between the fault components of the three phase currents is implemented, it will mean a downstream fault; and otherwise, it will mean a upstream fault.

The next question is that: when is the sum of the neutral point current IN and the capacitive currents $I_{C1}$ from all adjacent feeders a great enough value? i.e., the electric network under what condition can satisfy this kind of condition.

This depends on two factors:

the grounding type of a neutral point in a transformer of a transformer substation; and the total length of adjacent feeders.

In an effective neutral point grounding system, the current of the neutral point itself has been a great enough value so that the size of the capacitive current has been not important.

In an ineffective neutral point grounding system (commonly known as a small current grounding system, comprising the neutral point being not grounded, the neutral point being grounded through a high resistance and the neutral point being grounded through a peterson coil. The neutral point being not grounded and the neutral point being grounded through a high resistance are very similar, and will not be distinguished from each other in the following discussion), the network must have adjacent feeders having enough lengths. In other words, the network should have a plurality of feeders (>2). The condition can be satisfied under a general condition, since a transformer substation usually has 8-9 feeders on a bus. If a single phase fault occurs at the position shown in Fig. 1, then the fault components measured by IED D1 comprise IN, IC1 and IC2 (=IC2B+IC2C). If it is a system of the neutral point being not grounded, then the current passing the neutral point is 0, IN can be ignored, and there exist only capacitive currents. Therefore, IC1 must be great enough to make the assumption correct. If it is the neutral point being grounded through a peterson coil, since the impedance value of the peterson coil is adjusted according to the 50Hz power current, for high frequency capacitive charging and discharging currents occurred at transient states, the impendence of the peterson coil will increase along with frequency so that it can be approximately regarded as open circuited. Therefore, for high frequency capacitive currents, being grounded through a peterson coil is equivalent to a system not being grounded. At this time, the sizes of the high frequency capacitive currents at transient states are compared with each other. The detection time of the present invention is at fault transient states, and therefore a direction determination can be made by using a fast fading high frequency current. If the detection time is at fault steady states, and the high frequency current has completely faded, then since the peterson coil has an approximately completely canceling out effect on the steady state capacitive current, no obvious current variation can be measured at the fault phase, and then no information on a fault direction can be obtained.

Therefore, the fault direction in the grounding of a peterson coil is determined by using transient states, which is also a very large advantage of the present invention.

The fault identifying method according to the principles of the present invention considers having detected a fault, in case that the transient value of the residual current is higher than a preset value such as 10A.

The direction determination method according to the present invention is based on the following principles:

Principle 1: when there occurs a single phase grounding fault, the incremental current $\Delta I$ (the definition of $\Delta I$ is as shown in the following equation 1) of the two healthy phases the FPI will detect are very similar to each other. Therefore, the fault phase can be determined.

Principle 2: on a fault feeder, if it is a downstream fault, then the fault phase will have a $\Delta i$ value significantly greater than the $\Delta i$ values of the two healthy phases. If this condition is not satisfied, then the fault is an upstream fault.

The definitions of $\Delta i$ of such three phases as A, B and C are shown in equation 1:

$$\Delta i_A[k] = i_A[t+k-1] - i_A[t-N+k]$$
$$\Delta i_B[k] = i_B[t+k-1] - i_B[t-N+k]$$
$$\Delta i_C[k] = i_C[t+k-1] - i_C[t-N+k]$$
$$k = 1,2,3..N$$

Equation 1

wherein, N is the sampled points per period of the fault detecting device, such as 36. But it should be understood by those skilled in the art that different products may have different sample frequency values. t is a time point corresponding to the moment at which a fault has just been detected.

The direction determination method according to the present invention comprises the following steps:

1. Detecting a grounding fault:

The method detects a grounding fault by using a sample value (or transient value). Once the sample value is greater than a preset value such as 10A, then it is considered a grounding fault occurs. But it should be understood by those skilled in the art that the occurrence of the grounding fault can be detected by using other present or future methods.

2. Determining whether the fault is a single phase grounding fault or a two phase grounding fault

During a single phase grounding fault, two of the Δi values in a fault window (first period in which the fault has been detected) are very close with each other. The definition of the first period is as follows: assuming the subscript of the sample point corresponding to the moment the fault is detected is t, the sample point corresponding to the first period is [t, t+N-1]. Refer to Figs. 2, 3 and 4.

Fig. 2 shows a wave of a three phase current during a grounding fault of a phase A during a fault window (i.e., a first period after having detected a fault).

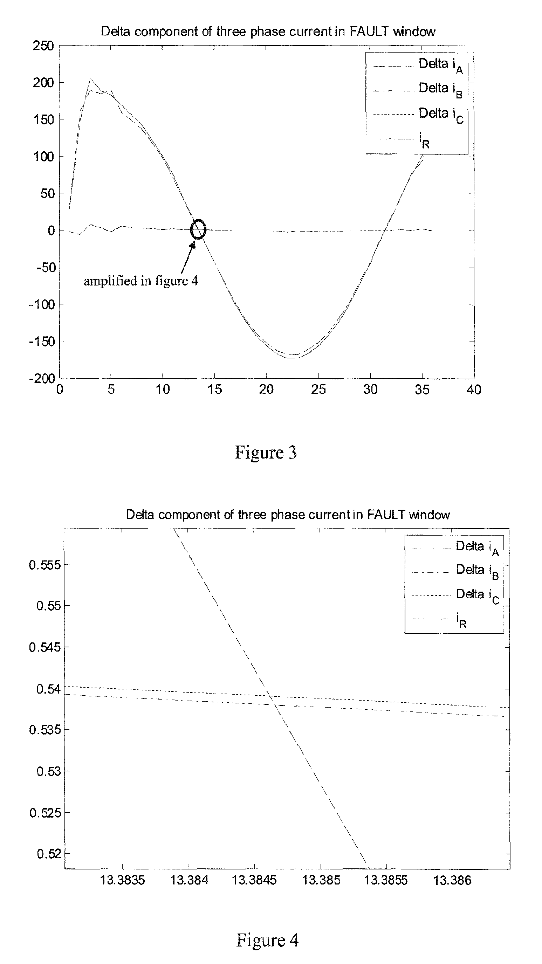

Fig. 3 shows a waveform of a three phase increment current Δi during the fault window. Phase B and phase C are very close to each other so that they almost overlap with each other.

Fig. 4 shows a waveform of a three phase Δi obtained by amplifying the circled part of Fig. 3 during phase A grounding fault during the fault window.

In order to quantify closeness between two Δi to describe the relation of "two of the Δi values are very close with each other", the variable GAP is defined as RMS of the difference value between the two Δi:

$$GAP_{AB} = \sqrt{\frac{\sum_{k=1}^{N}\left(\Delta i_{A}[k] - \Delta i_{B}[k]\right)^{2}}{N}}$$

$$GAP_{BC} = \sqrt{\frac{\sum_{k=1}^{N}\left(\Delta i_{B}[k] - \Delta i_{C}[k]\right)^{2}}{N}}$$

$$GAP_{AC} = \sqrt{\frac{\sum_{k=1}^{N}\left(\Delta i_{A}[k] - \Delta i_{C}[k]\right)^{2}}{N}} \qquad \text{Equation 2}$$

For example, if the grounded fault phase is only phase A, then the following equation 3 will be satisfied:

$$GAP_{BC} << GAP_{AB}$$
$$GAP_{BC} << GAP_{AC} \qquad \text{Equation 3}$$

In order to quantify the relation shown by the equation 3 for the fault of phase A, rate G is defined as follows:

$$G_{BC} = \frac{GAP_{BC}}{0.5\cdot(GAP_{AB} + GAP_{AC})} \cdot 100\%$$

$$G_{AB} = \frac{GAP_{AB}}{0.5\cdot(GAP_{BC} + GAP_{AC})} \cdot 100\%$$

$$G_{AC} = \frac{GAP_{AC}}{0.5\cdot(GAP_{AB} + GAP_{BC})} \cdot 100\% \qquad \text{Equation 4}$$

If there occurs a single phase grounding fault, one of the three rates G in equation 4 will be close to 0. For example, for phase A fault, it should be that GBC is close to 0.

If it is not satisfied that one in the GAP is far less than each of the other two, then it is a two phase grounding fault.

In addition, there exist other methods for identifying a single phase grounding fault and a two phase grounding fault. For example, when it is a two phase grounding, the phase current will be very large (for example, exceed 3-6 folds of load current). Therefore, the method for identifying a single phase grounding fault and a two phase grounding fault is not limited to the above mentioned method.

Although the foregoing gives a specific mode for quantifying closeness between two Δi, it should be understood by those skilled in the art that other quantifying modes existing at present or in the future according to the principles of the present invention are also in the protection scope of the present invention.

Likewise, although the foregoing gives a specific mode for quantifying various relations according to the principles of the present invention, it should be understood by those skilled in the art that other quantifying modes existing at present or in the future according to the principles of the present invention are also in the protection scope of the present invention.

3. For a single phase grounding fault, it is determined whether the fault is an upstream one or a downstream one:

It can be known from the principle described in the foregoing that, if, at fault transients, the current in a fault phase is significantly greater than that in a healthy phase, then it is determined that it is a downstream fault. That is, when compared to the two healthy phases the fault phase has a significant greater RMS value of Δi, it will be determined that it is a downstream fault.

$$\Delta I_A = \sqrt{\frac{\sum_{k=1}^{N} \left( \Delta i_A[k] \right)^2}{N}}$$

$$\Delta I_B = \sqrt{\frac{\sum_{k=1}^{N} \left( \Delta i_B[k] \right)^2}{N}}$$

$$\Delta I_C = \sqrt{\frac{\sum_{k=1}^{N} \left( \Delta i_C[k] \right)^2}{N}} \qquad \text{Equation 5,}$$

For the phase A fault, the following relations are satisfied, i.e., $\Delta I_A \gg \Delta I_B$ and $\Delta I_A \gg \Delta I_C$. Otherwise it is a upstream fault. For the phase A fault, in order to quantify the above relations, a proportional Yaw is defined as follows:

$$Yaw = \frac{\Delta I_A}{0.5 \cdot \left( \Delta I_B + \Delta I_C \right)} \cdot 100\% \qquad \text{Equation 6}$$

It should be understood by those skilled in the art that, for the above equation 6, the Numerator and Denominator will be changed according to the difference of the fault phase. That is, if it is a phase B fault, then the above equation 6

will become $Yaw = \dfrac{\Delta I_B}{0.5 \cdot \left( \Delta I_A + \Delta I_C \right)} \cdot 100\%$ while if phase C is a fault phase, then the above equation 6 will

become $Yaw = \dfrac{\Delta I_C}{0.5 \cdot \left( \Delta I_A + \Delta I_B \right)} \cdot 100\%$ .

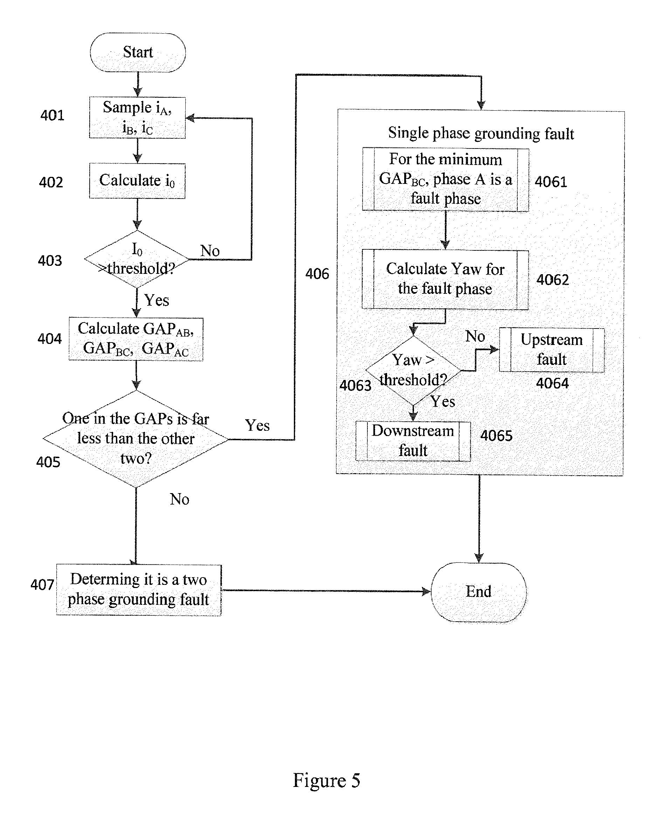

Fig. 5 shows a flowchart of a method for determining a fault direction according to an embodiment of the present invention.

As shown in Fig. 5, at step 401, phase currents $i_A$, $i_B$ and $i_C$ are sampled.

At step 402, $i_0$ is calculated. $i_0=(i_A+i_B+i_C)$, it is a transient value of a residual current. During the normal operation, since the three phase current is balanced, the residual current should be very close to 0.

At step 403, it is decided whether $i_0$ is greater than a threshold. If $i_0$ is greater than a first threshold, then it means a grounding fault is detected, and it proceeds to step 404, otherwise it returns to step 401. The first threshold is equal to 10, for example. The size of $i_0$ can be set by a user, such as 25A or 50A, and can also assume a very small value such as 1A. When the user ensures that there is no fault, and imbalance of elements of a current sensor and elements in a circuit will not cause a residual current greater than a certain value, this value can be considered as the first threshold. The smaller the first threshold is, the more sensitive the device is (can detect a grounding fault having a greater impedance value).

At step 404, $GAP_{AB}$, $GAP_{BC}$ and $GAP_{AC}$ are calculated.

At step 405, it is decided that whether one GAP value in the three GAPs calculated in step 404 is far less than the values of the other two. If yes, it is decided to be a single phase grounding fault and proceeds to step 406. if No, then it is decided that it is a two phase grounding fault, and proceeds to step 407.

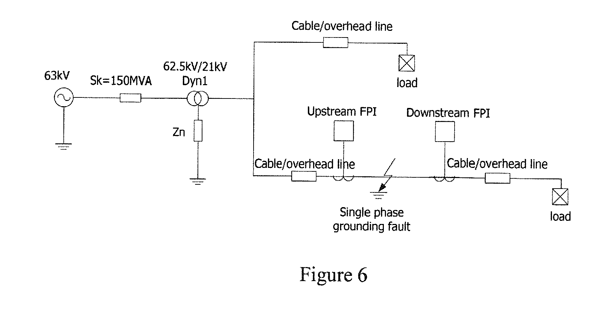

At step 406, the direction of the single phase grounding fault is further decided. The step 406 comprises step 4061, in which it is determined which phase is a fault phase. When $GAP_{AB}$ is the smallest, i.e., when rate GAB is less than a second threshold, phase C is a fault phase; when $GAP_{BC}$ is the smallest, i.e., when rate GBC is less than the second threshold, phase A is a fault phase; and when $GAP_{AC}$ is the smallest, i.e., when rate GAC is less than the second threshold, phase B is a fault phase. According to the simulation result with reference to Fig. 6, the value range of the second threshold is (35.82%, 131.71%), for example. At step 4062, Yaw value is calculated with respect to a fault phase. At step 4063, it is decided that whether Yaw value is greater than a third threshold. According to the simulation result with reference to Fig. 6, the value range of the third threshold is (500%, 600%), for example. If the result of the decision of step 4063 is "Yes", then it proceeds to step 4065 to decide it is a downstream fault. If the result of the decision of step 4063 is "No", then it proceeds to step 4064 to decide it is a upstream fault, and the process ends.

At step 407, it is determined whether it is two phase grounding fault, and the process ends.

The present invention intends to be implemented in a fault detecting application in the MV power distribution field, and is mainly used for:

- neutral point grounding modes in an HV/MV transformer substation adopt the following: direct grounding, impedance grounding, peterson coil grounding or not grounding;

- overhead and underground network FPSs and RTUs (Remote Terminal Unit);

- only phase current acquisition is possible or hopeful;

- when the grounding mode of the HV/MV distribution transformer is high impedance, peterson coil grounding or not grounding, there must exists a method capable of practicing the present invention when more than two feeders are coupled to the MV bus.

The method of the present invention can be applied to the following applications:

1> - a line fault indicator for an underground network, MV/LV transformer substation remote monitoring and control.

- a line fault indicator for an overhead network, LBS (Location Based Service) remote monitoring and control.

2> Underground network

- non-communication FPIs embedded in an MV power distribution cabinet (or having Modbus RS communication), mainly for new installations.
- wall mounted type non-communication FPIs particularly for later reformation.

Overhead network

At present, the overhead FPI uses two kinds of techniques: clip-on or pole-mounted.

It is considered that the measurement accuracy of the pole-mounted technical voltage remote sensing is greatly influence by the environment and therefore can not meet the global needs reliably.

Therefore, the method of the present invention can provide a solution suitable for the clip-on technique, such as

- a product having a collecting unit and a gateway.

In the following, the simulation result of the directional grounding fault detecting method according to the present invention will be described in conjunction with Fig. 6.

In order to test the directional grounding fault detecting method according to the present invention, a 20kV distribution network is modeled in EMTP (Electro-Magnetic Transient Program). The used circuit parameters are as follows:

Underground cable parameters: $Z1=$ (0.15+j0.099)Ohm/km, $C1=$ 0.25uF/km, $Z0=$ (0.3+j0.1256)Ohm/km, C0=0.25uF/km, a length of 0.2 to 30 km

Overhead line parameters: $Z1=$ (0.25+j0.382)Ohm/km, C1=0.00756uF/km, $Z0=$ (0.5+j0.5005)Ohm/km, C0=0.00756uF/km, a length of 0.2 to 30 km

Transformer neutral point grounding mode: resistive, peterson coil and not grounded

Fault resistance: from 0.01 to 300 Ohm

Power transformer parameters: P0=21kW, I0=0.7%, Uk=12%, Pk=104kW

System short circuit power: Sk= 150MVA

Load power factor: $\cos\varphi$=0.9

Fig. 6 shows a simplified schematic simulation circuit for a method for determining a directional grounding fault according the present invention.

Firstly, it will be detected whether assumption 1 is correct:

When there occurs a single phase grounding fault, the FPI will detect the $\Delta I$ of the two healthy phases are very close with each other. Therefore, the fault phase can be determined.

There are provided statistical data of three kinds of FPI positions in the following:

Downstream fault: GBC = [0.07%, 3.46%], GAB= [163.27%, 199.99%], GAC= [163.27%, 199.99%]

Upstream fault: GBC = [0.38%, 35.82%], GAB= [148.72%, 199.23%], GAC= [131.71%, 199.23%]

It can be known from the above simulation result that, obviously, a threshold located at any position between 35.82% and 131.71% can identify which phase has a fault in all cases.

Secondly, it will be detected whether assumption 2 is correct:

If it is a downstream fault, then the fault phase will have a $\Delta I$ value which is significantly greater than the $\Delta I$ value of the two healthy phases. If the above condition is not satisfied, then the fault is a upstream fault.

The following are statistical data of simulation of the FPI on a fault feeder:

Downstream fault: Yaw= [600%, 72621.88%]
Upstream fault: Yaw= [20.92%, 500%]

Therefore, it can be known from the above simulation result that, obviously for all the cases, any threshold selected between 500% and 600% can identify whether it is a downstream fault or an upstream fault.

The foregoing is illustrative of the present invention and is not to be construed as limiting thereof. Although a few embodiments of the present invention have been described, those skilled in the art will readily appreciate that many modifications can be made to the exemplary embodiments without departing from the novel teachings and advantages of the present invention. Accordingly, all such modifications are intended to be included within the scope of the present invention as defined in the claims. It should be understood that the foregoing is illustrative of the present invention and is not to be construed as being limited to the disclosed particular embodiments of the present disclosure, and modifications to the disclosed embodiments and other embodiments are intended to be included within the scope of the appended claims. The present invention is defined by the claims and equivalents thereof.

**Claims**

1. A directional grounding fault detecting method, comprising:

    a. detecting a grounding fault based on sampled three phase currents $i_A$, $i_B$ and $i_C$, and obtaining a time point t corresponding to an moment at which the grounding fault is just detected;
    b. determining whether it is a single phase grounding fault or a two phase grounding fault based on three incremental phase currents $\Delta i_A$, $\Delta i_B$ and $\Delta i_C$ at moment t; and
    c. when it is determined as a single phase grounding fault, it is determined whether the fault is an upstream fault or a downstream fault based on an amplitude of the incremental phase current of the faulted phase.

2. The method according to claim 1, wherein the step b further comprises: b1) determining whether it is a single phase grounding fault or a two phase grounding fault by comparing closeness of three incremental phase currents $\Delta i_A$, $\Delta i_B$ and $\Delta i_C$ at moment t.

3. The method according to claim 2, wherein the step b1) further comprises: b11) calculating an Root mean square RMS of a difference value of every two incremental phase currents in the three incremental phase currents at the moment t to obtain three difference value variables $GAP_{AB}$, $GAP_{BC}$ and $GAP_{AC}$; if one of the three difference value variables $GAP_{AB}$, $GAP_{BC}$ and $GAP_{AC}$ is far less than the other two, it is decided that it is a single phase grounding fault; and otherwise, it is decided it is a two phase grounding fault.

4. The method according to claim 3, wherein the three incremental phase currents at the moment t are calculated based on the following equation:

$$\Delta i_A[k] = i_A[t+k-1] - i_A[t-N+k]$$
$$\Delta i_B[k] = i_B[t+k-1] - i_B[t-N+k]$$
$$\Delta i_C[k] = i_C[t+k-1] - i_C[t-N+k]$$
$$k = 1,2,3..N$$

wherein, $\Delta i_A$ is phase A incremental current, $\Delta i_B$ is phase B incremental current, $\Delta i_C$ is phase C incremental current, $i_A$ is phase A current, $i_B$ is phase B current, $i_C$ is phase C current, and N is a number of sample values, and the three difference value variables $GAP_{AB}$, $GAP_{BC}$ and $GAP_{AC}$ are calculated based on the following equation:

$$GAP_{AB} = \sqrt{\frac{\sum_{k=1}^{N}\left(\Delta i_A[k] - \Delta i_B[k]\right)^2}{N}}$$

$$GAP_{BC} = \sqrt{\frac{\sum_{k=1}^{N}\left(\Delta i_B[k] - \Delta i_C[k]\right)^2}{N}}$$

$$GAP_{AC} = \sqrt{\frac{\sum_{k=1}^{N}\left(\Delta i_A[k] - \Delta i_C[k]\right)^2}{N}}$$

.

5. The method according to claim 4, wherein step c further comprises:

    c1) deciding two phases having a minimum difference value variable is healthy phases and the other phase is a fault phase; and
    c2) calculating RMS values of the three incremental phase currents $\Delta i_A$, $\Delta i_B$ and $\Delta i_C$ at the moment t, and when, compared to the two healthy phases, a fault phase has a significantly great RMS value of the incremental phase current, it is determined it is a downstream fault; and otherwise, it is determined it is an upstream fault.

6. The method according to claim 5, wherein step c2 further comprises: calculating an average value Yaw of the difference value variable of the fault phase and the difference value variables of the two healthy phases; if the Yaw value is greater than a third threshold, it is determined it is a downstream fault; and otherwise, it is determined it is an upstream fault.

7. The method according to claim 6, wherein, the RMS values of the three incremental phase currents $\Delta i_A$, $\Delta i_B$ and $\Delta i_C$ are calculated according to the following equation:

$$\Delta I_A = \sqrt{\frac{\sum_{k=1}^{N}\left(\Delta i_A[k]\right)^2}{N}}$$

$$\Delta I_B = \sqrt{\frac{\sum_{k=1}^{N}\left(\Delta i_B[k]\right)^2}{N}}$$

$$\Delta I_C = \sqrt{\frac{\sum_{k=1}^{N}\left(\Delta i_C[k]\right)^2}{N}} \; ;$$

and
the Yaw value is calculated according to the following equation:

$$Yaw = \frac{\Delta I_{fault\ phase}}{0.5 \cdot \left(\Delta I_{first\ healty\ phase} + \Delta I_{second\ healthy\ phase}\right)} \cdot 100\% .$$

8. The method according to any of claims 1-7, wherein the step a further comprises:

when a sum of the three phase currents $i_A$, $i_B$ and $i_C$ is greater than the first threshold, then it is determined a grounding fault is detected.

9. A directional grounding fault detecting device, comprising:

a grounding fault detecting module for detecting a grounding fault based on sampled three phase currents $i_A$, $i_B$ and $i_C$, and obtaining a time point t corresponding to an moment at which the grounding fault is just detected;
a single phase grounding fault determining module for determining whether it is a single phase grounding fault or a two phase grounding fault based on three incremental phase currents $\Delta i_A$, $\Delta i_B$ and $\Delta i_C$ at moment t; and,
a fault direction determining module for, when it is determined as a single phase grounding fault, determining whether the fault is an upstream fault or a downstream fault based on an amplitude of the incremental phase current of the faulted phase.

10. The device according to claim 9, wherein the single phase grounding fault determining module further comprises a first comparing module for determining whether it is a single phase grounding fault or a two phase grounding fault by comparing closeness of three incremental phase currents $\Delta i_A$, $\Delta i_B$ and $\Delta i_C$ at moment t.

11. The device according to claim 10, wherein the single phase grounding fault determining module further comprises a first calculating module for calculating an RMS of a difference value of every two incremental phase currents in the three incremental phase currents at the moment t to obtain three difference value variables $GAP_{AB}$, $GAP_{BC}$ and GAP$_{AC}$; and

the first comparing module compares the three difference value variables GAP$_{AB}$, GAP$_{BC}$ and GAP$_{AC}$ with each other, and if one of the three difference value variables GAP$_{AB}$, GAP$_{BC}$ and GAP$_{AC}$ is far less than the other two, it is decided that it is a single phase grounding fault; and otherwise, it is decided it is a two phase grounding fault.

12. The device according to claim 11, wherein the three incremental phase currents at the moment t are calculated based on the following equation:

$$\Delta i_A[k] = i_A[t+k-1] - i_A[t-N+k]$$
$$\Delta i_B[k] = i_B[t+k-1] - i_B[t-N+k]$$
$$\Delta i_C[k] = i_C[t+k-1] - i_C[t-N+k]$$
$$k = 1, 2, 3..N$$

wherein, $\Delta i_A$ is phase A incremental current, $\Delta i_B$ is phase B incremental current, $\Delta i_C$ is phase C incremental current, $i_A$ is phase A current, $i_B$ is phase B current, $i_C$ is phase C current, and N is a number of sample values, and the three difference value variables GAP$_{AB}$, GAP$_{BC}$ and GAP$_{AC}$ are calculated based on the following equation:

$$GAP_{AB} = \sqrt{\frac{\sum_{k=1}^{N} \left(\Delta i_A[k] - \Delta i_B[k]\right)^2}{N}}$$

$$GAP_{BC} = \sqrt{\frac{\sum_{k=1}^{N} \left(\Delta i_B[k] - \Delta i_C[k]\right)^2}{N}}$$

$$GAP_{AC} = \sqrt{\frac{\sum_{k=1}^{N} \left(\Delta i_A[k] - \Delta i_C[k]\right)^2}{N}}$$

13. The device according to claim 12, wherein the fault direction determining module further comprises:

a fault phase deciding module for deciding two phases having a minimum difference value variable is healthy phases and the other phase is a fault phase; and
a second calculating module for calculating RMS values of the three incremental phase currents $\Delta i_A$, $\Delta i_B$ and $\Delta i_C$ at the moment t; and
a second comparing module for comparing the RMS values of the three incremental phase currents, and when, compared to the two healthy phases, a fault phase has a markedly great RMS value of the incremental phase current, it is determined it is a downstream fault; and otherwise, it is determined it is an upstream fault.

14. The device according to claim 13, wherein
the second calculating module further calculates an average value Yaw of the difference value variable of the fault phase and the difference value variables of the two healthy phases; and
the second comparing module further compares the Yaw value and a third threshold, and if the Yaw value is greater than the third threshold, it is determined it is a downstream fault; and otherwise, it is determined it is an upstream fault.

15. The device according to any of claims 9-14, wherein the grounding fault detecting module further comprises:

a fourth comparing module for comparing a sum of the three phase currents $i_A$, $i_B$ and $i_C$ with the first threshold, and when the sum of the three phase currents $i_A$, $i_B$ and $i_C$ is greater than the first threshold, then it is determined a grounding fault is detected.

Figure 1

Figure 2

Figure 3

Figure 4

Figure 5

Figure 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 239098 A1
- WO 2011023305 A1
- JP 2009526203 B
- JP 2009038912 A
- JP 4215656 B